# EUROPEAN PATENT APPLICATION

(11) **EP 4 297 274 A1**
(43) Date of publication of application: **27.12.2023**
(21) Application number: 22305921.3
(22) Date of filing: 24.06.2022
(51) Int. Cl.: H03F 1/02, H03F 1/56, H03F 3/195, H03F 3/213, H01L 23/66

(54) **FLIP CHIP DOHERTY AMPLIFIER DEVICES**

(71) Applicant: Wolfspeed, Inc., Durham, NC 27703 (US)
(72) Inventor: BOUISSE, Gerard, 31470 Saint-Lys (FR)
(74) Representative: Boult Wade Tennant LLP

(57) **Abstract**

A power amplifier includes a substrate, first and second transistor amplifiers, and at least one matching circuit. Respective output terminals of the first and second transistor amplifiers are coupled to a combining node, and the matching circuit includes one or more passive electrical components coupled between one of the respective output terminals and the combining node. At least one of the first and second transistor amplifiers or the one or more passive electrical components is mounted on the substrate in a flip chip configuration. The matching circuit may include a shunt inductance that is coupled to the one of the respective drain terminals by a conductive bump. Related devices are also discussed.

## Description

### FIELD

The present disclosure relates to transistor devices, and more particularly, to high power transistor devices.

### BACKGROUND

Electrical circuits requiring high power handling capability while operating at high frequencies, such as radio frequencies (500 MHz), S-band (3 GHz) and X-band (10 GHz), have in recent years become more prevalent. Because of the increase in high power, high frequency circuits, there has been a corresponding increase in demand for semiconductor devices which are capable of reliably operating at radio and microwave frequencies while still being capable of handling high power loads.

Radio Frequency (RF) power amplifiers in communication systems may be used for generating the high power needed for wireless communications. A power amplifier (PA) may include one or more active transistors and passive matching networks at the input and output nodes. Different RF power applications may have differing requirements for power amplifiers, for example, with respect to output power and efficiency. In general, a power amplifier operates at maximum power efficiency when the power amplifier transmits close to saturated power. However, power efficiency tends to worsen as output power decreases. For example, RF PAs used in base stations may need to be efficient not only at peak power, but also at average power, which may be several decibels (dB) below peak power. However, achieving this goal may be challenging because peak efficiency may be reached near peak power. At back-off or average power, the efficiency tends to drop drastically.

To address efficiency at back-off power, several PA architectural solutions have been proposed, including Doherty implementations. A Doherty type linear amplifier configuration may provide increased linearity and efficiency in a linear amplifier topology. In general, a Doherty amplifier includes two amplifiers having their output power combined through a load modulation network. A Doherty amplifier thus includes at least two amplifier paths, a carrier amplifier path and a peaking amplifier path, and combines the output of these two paths at a summing junction (or node) in such a way as to provide for the increased linearity and efficiency. Various Doherty amplifier implementations are described in U.S. Pat. No. 6,700,444 to Pengelly, U.S. Pat. No. 6,737,922 to Pengelly et al., U.S. Pat. No. 6,791,417 to Pengelly et al., U.S. Pat. No. 7,193,473 to Pengelly et al., U.S. Pat. No. 9,407,214 Pribble et al., and "A Wideband and Compact GaN MMIC Doherty Amplifier for Microwave Link Applications" by Gustafsson et al., IEEE Transactions on Microwave Theory and Techniques, Vol. 61, No. 2 (February 2013).

In a traditional Doherty amplifier configuration, a carrier amplifier receives an undelayed input signal for amplification, and a peaking amplifier receives a phase delayed input signal for amplification. An integrated Doherty configuration may implement this phase delay using a lumped element impedance inverter. More recently, electronic systems have been designed using a so called "inverted" Doherty amplifier configuration. In an inverted Doherty configuration, the carrier amplifier receives the delayed input signal for amplification, and the peaking amplifier receives the undelayed input signal for amplification.

The high efficiency of the Doherty architecture may be desirable for current and nextgeneration wireless systems. However, the architecture presents challenges in terms of semiconductor package design. Some Doherty amplifier semiconductor package designs may use discrete devices, conductors, and integrated circuits to implement each amplification path. For example, the carrier and peaking amplification paths each may include a distinct power transistor die, along with distinct inductance and capacitance components. These distinct power transistor die and components are maintained a distance apart from one another in a typical device package in order to limit potential performance degradation that may occur due to signal coupling between the carrier and peaking amplifiers. More specifically, undesirable signal coupling between the carrier and peaking amplifiers may involve the transfer of energy between components of the carrier and peaking amplifier paths through magnetic and/or electric fields associated with the signals carried on those amplifier paths.

### SUMMARY

According to some embodiments of the present disclosure, a power amplifier includes a substrate, first and second transistor amplifiers having respective output terminals coupled to a combining node, and a matching circuit comprising one or more passive electrical components coupled between one of the respective output terminals and the combining node. At least one of the first and second transistor amplifiers or the one or more passive electrical components is mounted on the substrate in a flip chip configuration.

In some embodiments, the one of the respective output terminals is a drain terminal, and the one or more passive electrical components comprises a shunt inductance that is coupled to the drain terminal by a conductive bump.

In some embodiments, the one or more passive electrical components comprises at least one integrated passive device (IPD) that is mounted on the substrate in the flip chip configuration and provides the shunt inductance.

In some embodiments, the substrate comprises a multi-layer laminate, and the one or more passive electrical components comprises at least one inductor that is in the multi-layer laminate and provides the shunt inductance.

In some embodiments, the shunt inductance is free of wirebonds.

In some embodiments, the drain terminal is coupled to the shunt inductance free of a wire bond pad therebetween.

In some embodiments, an electrical path between the one of the respective output terminals and the combining node is free of wirebonds.

In some embodiments, the one of the respective output terminals is a drain terminal of the first transistor amplifier, the matching circuit is a first output matching circuit, and the shunt inductance is a first shunt inductance. A second output matching circuit is coupled between a drain terminal of the second transistor amplifier and the combining node, the second output matching circuit comprising a second shunt inductance coupled to the drain terminal of the second transistor amplifier by a conductive bump.

In some embodiments, the first and second transistor amplifier dies comprise a main amplifier and a peaking amplifier, respectively, in a Doherty configuration.

In some embodiments, a load impedance matching circuit may be coupled between the combining node and an output lead. An impedance of the load impedance matching circuit is based on an asymmetry factor between the peaking amplifier and the main amplifier and is about 1.5 times to 4 times an impedance at the output terminal of the main amplifier.

In some embodiments, the matching circuit is configured to delay a phase of an output signal from the one of the respective output terminals by a quarter wavelength.

In some embodiments, a package housing may include the substrate, the first and second transistor amplifiers, and the matching circuit therein.

According to some embodiments, a transistor amplifier package includes a main transistor amplifier and a peaking transistor amplifier. Respective output terminals of the main and peaking transistor amplifiers are coupled to a combining node. An electrical path between one of the respective output terminals and the combining node is free of wirebonds.

In some embodiments, a matching circuit comprising one or more passive electrical components may be coupled between the one of the respective output terminals and the combining node.

In some embodiments, the one of the respective output terminals is a drain terminal, and the one or more passive electrical components comprises a shunt inductance that is coupled to the drain terminal by a conductive bump.

In some embodiments, the package may include a substrate, and at least one of the main and peaking transistor amplifiers or the one or more passive electrical components may be mounted on the substrate in a flip chip configuration.

In some embodiments, the one or more passive electrical components comprises at least one integrated passive device (IPD) that is mounted on the substrate in the flip chip configuration and provides the shunt inductance.

In some embodiments, the substrate comprises a multi-layer laminate, and the one or more passive electrical components comprises at least one inductor that is in the multi-layer laminate and provides the shunt inductance.

In some embodiments, the one of the respective output terminals is a drain terminal of the main transistor amplifier, the matching circuit is a first output matching circuit configured to delay a phase of an output signal from the main transistor amplifier by a quarter wavelength, and the shunt inductance is a first shunt inductance. A second output matching circuit is coupled between a drain terminal of the peaking transistor amplifier and the combining node and configured to delay a phase of an output signal from the peaking transistor amplifier by a quarter wavelength, the second output matching circuit comprising a second shunt inductance coupled to the drain terminal of the peaking transistor amplifier by a conductive bump.

In some embodiments, a load impedance matching circuit may be coupled between the combining node and an output lead of the transistor amplifier package. An impedance of the load impedance matching circuit is about 1.5 times to 4 times an impedance at the output terminal of the main transistor amplifier.

According to some embodiments, a power amplifier includes a first transistor amplifier and a second transistor amplifier, where respective drain terminals of the first and second transistor amplifiers are coupled to a combining node, and a matching circuit coupled between one of the respective drain terminals and the combining node, where the matching circuit comprises a shunt inductance that is coupled to the one of the respective drain terminals by a conductive bump.

In some embodiments, the one of the respective drain terminals is coupled to the shunt inductance free of a wire bond pad therebetween.

In some embodiments, an electrical path between the one of the respective drain terminals and the combining node is free of wirebonds.

In some embodiments, the power amplifier further comprises a substrate. In some embodiments, at least one of the first and second transistor amplifiers or the one or more passive electrical components is mounted on the substrate in a flip chip configuration.

In some embodiments, the one or more passive electrical components comprises at least one integrated passive device (IPD) that is mounted on the substrate in the flip chip configuration and provides the shunt inductance.

In some embodiments, the substrate comprises a multi-layer laminate, and the one or more passive electrical components comprises at least one inductor that is in the multi-layer laminate and provides the shunt inductance.

In some embodiments, the first and second transistor amplifier dies comprise a main amplifier and a peaking amplifier, respectively, in a Doherty configuration.

In some embodiments, an impedance at the combining node is about 1.5 times to 4 times an impedance at the drain terminal of the main amplifier.

In some embodiments, the power amplifier further comprises a package housing. In some embodiments, the package housing includes the first and second transistor amplifiers and the matching circuit therein.

Other devices, apparatus, and/or methods according to some embodiments will become apparent to one with skill in the art upon review of the following drawings and detailed description. It is intended that all such additional embodiments, in addition to any and all combinations of the above embodiments, be included within this description, be within the scope of the invention, and be protected by the accompanying claims.

### BRIEF DESCRIPTION OF THE DRAWINGS

The accompanying drawings, which are included to provide a further understanding of the invention and are incorporated in and constitute a part of this application, illustrate certain embodiment(s) of the disclosure. In the drawings:
FIG. 1 is a plan view of a conventional multi-cell transistor device.
FIG. 2A is a circuit diagram of a PA including multiple transistor amplifiers coupled in parallel in accordance with some embodiments of the present disclosure. FIG. 2B is a circuit diagram illustrating the output section of the PA of FIG. 2A in greater detail.
FIG. 3A is a plan view of a PA including multiple transistor amplifiers coupled in parallel and respective matching and phase delay circuits in accordance with some embodiments of the present invention. FIG. 3B is a plan view illustrating the transistor amplifiers of FIG. 3A in greater detail.
FIGS. 4A and 4B are cross-sectional views illustrating example transistor amplifier packages in accordance with some embodiments of the present disclosure.
FIGS. 5A and 5B are cross-sectional views illustrating example transistor amplifier packages in accordance with further embodiments of the present disclosure.
FIGS. 6A and 6B are cross-sectional views illustrating example product applications of transistor amplifier packages in accordance with some embodiments of the present disclosure.
FIGS. 7A and 7B are plan and perspective views, respectively, illustrating examples of integrated passive devices (IPDs) that may be used to implement passive electrical components for matching circuits and/or phase delay circuits in accordance with some embodiments of the present disclosure.
FIGS. 8A and 8B are cross sectional views illustrating distributed element circuits that can be used that may be used to implement passive electrical components for matching circuits and/or phase delay circuits in accordance with some embodiments of the present disclosure.
FIGS. 9A, 9B, 9C, and 9D are graphs illustrating performance of output matching circuits in accordance with some embodiments of the present disclosure.

### DETAILED DESCRIPTION OF EMBODIMENTS

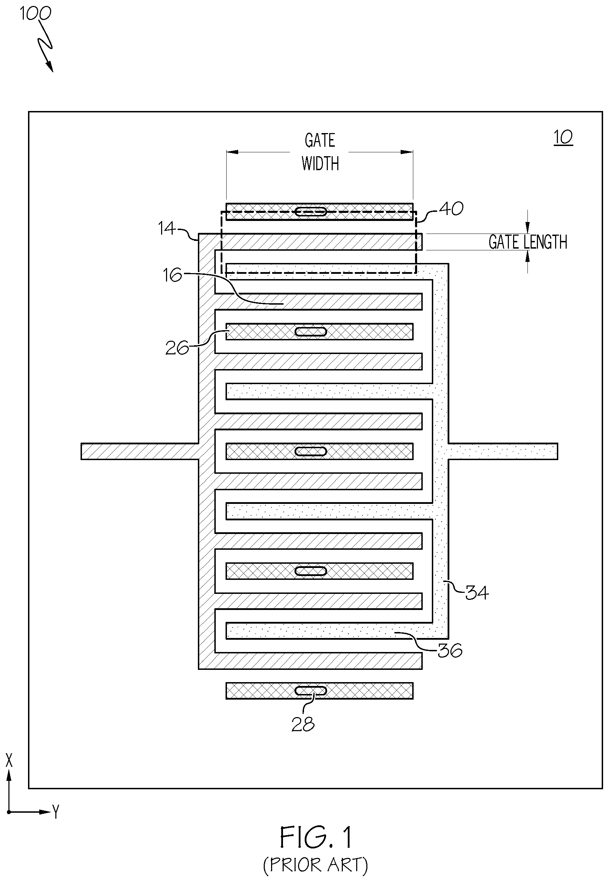

Some power amplifier configurations described herein may be implemented using a plurality of "unit cell" transistors that are fabricated on a common semiconductor die, with a plurality of the unit cells defining each transistor amplifier device. Each unit cell transistor may include a source region, a drain region and a channel region in a semiconductor material, with the channel region being between the source and drain regions. A gate electrode or terminal (or "gate"), which may be implemented as an elongated gate finger, is formed above the channel region and extends in parallel between source and drain contacts, as is schematically illustrated in FIG. 1. While described herein primarily with reference to high electron mobility transistors ("HEMTs"), it will be understood that embodiments of the present disclosure are not limited to any particular transistor type, and may include, for example, metal-oxide-semiconductor field effect transistor (MOSFET) embodiments, such as laterally diffused MOSFETs (LDMOS) embodiments.

As shown in FIG. 1, a unit cell transistor of a power amplifier semiconductor device 100 is illustrated at box 40, and includes an electrically conductive gate finger 16 that extends between adjacent source and drain fingers 26 and 36 on a semiconductor structure 10, such as a gallium nitride (GaN) and/or silicon carbide (SiC) semiconductor structure. The gate fingers 16 of respective unit cells 40 are spaced apart from each other along a first direction (e.g., the x-direction in FIG. 1) and extend (e.g., in parallel) in a second direction (e.g., the y-direction in FIG. 1).

The gate fingers 16 are electrically connected to each other through a gate bus 14, which may be coupled to or may include a gate pad (also referred to herein as a gate terminal) for external connection. Electrically conductive source fingers 26 are spaced apart from each other along the first direction and extend in the second direction. The source fingers 26 may be electrically connected to each other by through vias 28 or other structures (not visible in FIG. 1), and may be coupled to or may include a source pad (also referred to herein as a source terminal) for external connection. In some embodiments, the source fingers 26 may be electrically connected to a source contact or pad (not visible in FIG. 1) on the bottom side of the semiconductor structure 10. Electrically conductive drain fingers 36 are likewise spaced apart from each other along the first direction and extend in the second direction, and are electrically connected to each other through a drain bus 34, which may be coupled to or may include a drain pad (also referred to herein as a drain terminal) for external connection.

The gate, source, and drain fingers 16, 26, 36 may each comprise a respective conductive material, such as a metal or a metal alloy. Each gate finger 16 extends along the y-direction between a pair of adjacent source and drain fingers 26, 36. The "gate length" refers to the distance of the gate metallization in the x-direction (between source and drain fingers 26 and 36), while the "gate width" is the distance by which the gate fingers 16 and the source and drain contacts 26 and 36 overlap in the y-direction. That is, "width" of a gate finger 16 refers to the dimension of the gate finger 16 that extends in parallel to the adjacent source/drain contacts 26, 36 (the distance along the y-direction). The power handling capability of the semiconductor device 10 may be proportional to its "gate periphery." The gate periphery of semiconductor device 10 may refer the sum of the gate lengths for each gate finger 16 for each unit cell transistor 40 thereof.

Some embodiments of the present disclosure are directed to power amplifier configurations including two or more transistor amplifier devices that are fabricated and electrically connected in parallel in a common package. Some multi-stage power amplifier configurations may include high power transistor structures that can maintain efficiency when operating at back-off or average power, such as Doherty configurations. A typical two-way Doherty amplifier configuration includes a RF signal splitter configured to divide an input RF signal into two signals (referred to as a carrier signal and a peaking signal herein). The Doherty amplifier also includes parallel carrier and peaking amplifier paths configured to amplify the carrier and peaking signals, respectively, and a signal combiner configured to combine the amplified carrier and peaking signals. The carrier amplifier may also be referred to herein as a main amplifier. In addition, various phase shift or phase delay elements are provided along the main and/or peaking amplifier paths. The terms phase shift and phase delay may be used interchangeably herein.

The Doherty configuration may involve two RF bandwidths (peak/full power and average power) and an instantaneous bandwidth. The peak or full power bandwidth may represent the signal bandwidth when both current sources (the main and peaking amplifiers) are on. The average or back-off power bandwidth may represent the signal bandwidth when only one current source (the main amplifier) is on, and the other (the peaking amplifier) is off. The instantaneous bandwidth (IBW) may represent the maximum modulating signal bandwidth that can be amplified without asymmetrical distortion, and may also referred to as video bandwidth (VBW).

The main amplifier and the peaking amplifier each may be implemented using a singlestage or multiple-stage power transistor devices. Using nomenclature typically applied to field effect transistors (FETs), the main amplifier and the peaking amplifier each may include an input or control terminal (e.g., a gate) configured to receive an input RF signal, and two output or current conducting terminals (e.g., a drain terminal and a source terminal). In some configurations, each source terminal is coupled to a ground reference node, and the amplified carrier and peaking signals are output at the drain terminals of the main amplifier and the peaking amplifier, respectively, and may be combined at a combining node to provide the RF output signal.

For example, in a typical non-inverted Doherty amplifier architecture, a quarter wavelength (λ/4) transmission line applies a 90 degree phase shift to the peaking signal prior to amplification along the peaking amplifier path, and a corresponding transmission line applies a 90 degree phase shift to the carrier signal after amplification along the main amplifier path, but before the amplified carrier and peaking signals are combined together in phase. The drain of the peaking amplifier may serve as the combining node for the amplified RF signals produced by the carrier and peaking amplifiers in a non-inverted Doherty configuration.

Conversely, in a typical inverted Doherty amplifier architecture, a 90 degree phase shift is applied to the carrier signal prior to amplification along the main amplifier path, and a 90 degree phase shift is applied to the peaking signal after amplification along the peaking amplifier path, before the amplified carrier and peaking signals are combined together in phase. The drain of the main amplifier may serve as the combining node for the amplified RF signals produced by the carrier and peaking amplifiers in an inverted Doherty configuration.

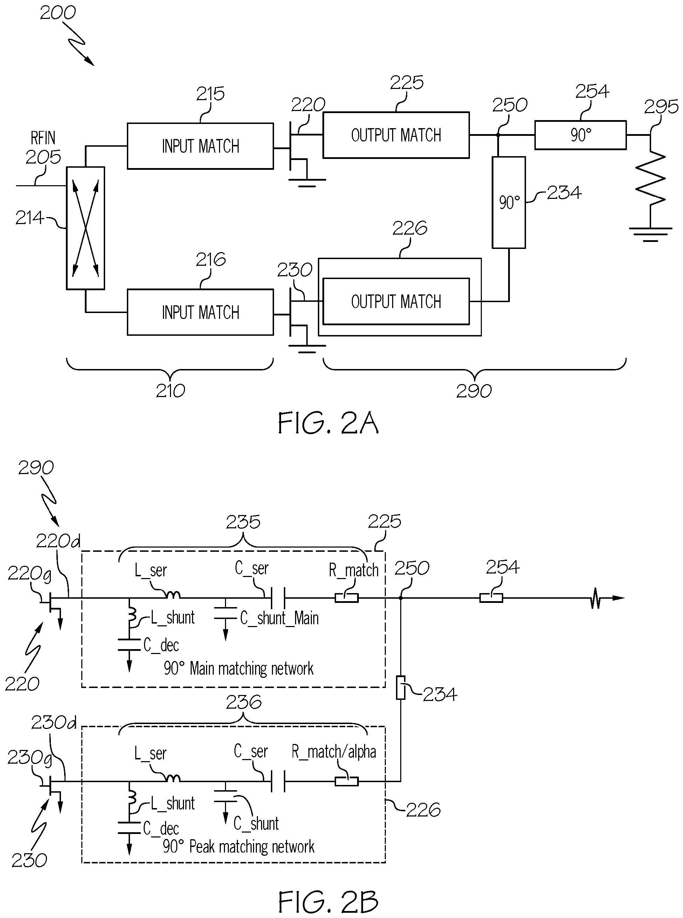

FIG. 2A is circuit diagram of a PA 200 in accordance with some embodiments of the present disclosure. In the example of FIG. 2A, the PA is implemented in a Doherty configuration, but it will be understood that embodiments of the present invention may include any amplifier configuration with two or more parallel amplification stages.

As shown in FIG. 2A, the PA 200 includes at least two transistor amplifiers, illustrated as a carrier (or "main") transistor amplifier 220 and at least one peaking transistor amplifier 230 that are electrically connected in parallel, and a power splitter or divider circuit 214 is configured to receive an input power signal (e.g., an RF or other AC input signal) at an input lead 205 and provide respective component input signals to inputs of the main amplifier 220 and the peaking amplifier 230 via respective input impedance matching circuits 215 and 216. In some embodiments, the power splitter 214 may be implemented as part of or may include an input transmission line that couples the inputs of the main amplifier 220 and the peaking amplifier 230. The electrical components between the input lead 205 and the inputs of the transistor amplifiers 220 and 230 (e.g., the power splitter 214 and the input matching circuits 215 and 216) may be referred to as the input section 210 of the PA 200.

The main 220 and peaking 230 amplifiers are configured to receive and amplify respective ones of the component input signals to generate amplified component output signals, and are configured to turn on at different power levels of the input signal. For example, the main amplifier 220 may be biased to operate in Class B or Class AB mode, while the peak amplifier 230 may be biased to only amplify signals which exceed some minimum threshold, e.g., by DC biasing the transistors of the peak amplifier 230 below pinch-off voltage, for operation similar to Class C.

A combiner and impedance inverter circuit 234 couples an output of the main amplifier 220 to an output of the peaking amplifier 230 via respective output impedance matching circuits 225 and 226, and is configured to receive and combine the amplified component output signals at an output combining node 250. In some embodiments, the impedance inverter circuit 234 and the combining node 250 may be implemented as part of or may include an output transmission line that couples the outputs of the main amplifier 220 and the peaking amplifier 230 to an output lead 295. The electrical components between the outputs of the transistor amplifiers 220 and 230 and an output lead 295 (e.g., output matching circuits 225 and 226, the impedance inverter circuit 234) may be referred to as the output section 290 of the PA 200.

Accordingly, the outputs of the main amplifier 220 and the peak amplifier 230 are not isolated from one another. Thus, when the peaking amplifier 230 turns on, the apparent load presented to the main amplifier 220 changes. When the input RF power into the Doherty amplifier 200 is not sufficient to turn on the peak amplifier 230, substantially all of the output power is supplied by the main amplifier 220 . When the peak amplifier 230 is off, its output impedance is very high and the output power of the main amplifier 220 is essentially all delivered to the load. The peaking amplifier 230 may become active only during the peaks of the input signal. When the peak amplifier 230 is active, the load impedance apparent at the output of the main amplifier 220 is reduced. The peak amplifier 230 may be designed to begin operation when the main amplifier 220 begins to saturate, which may increase linear efficiency. The power splitter 214, the transistor amplifiers 220 and 230, and the combiner and impedance inverter circuit 234 may be included in an integrated circuit package, such as the transistor amplifier package 300 discussed below.

The impedance inverter circuit 234 may include one or more phase delay elements, and may be represented as a transmission line having an electrical length (also referred to as phase length) configured to provide a predetermined phase shift and impedance inversion between the outputs of the main and peaking amplifiers 220 and 230, with the drain of the main amplifier 220 electrically coupled to a first end of the transmission line 234 by output matching circuit 225, and the drain of the peaking amplifier 230 electrically coupled to a second end of the transmission line 234 by output matching circuit 226. The electrical length of the impedance inverter circuit 234 may be configured such that both amplifiers 220 and 230 see their optimum load resistance to provide maximum power and efficiency.

The PA 200 shown in FIG. 2A is shown by way of example in an inverted Doherty configuration, which may be configured to balance the full power and average power RF bandwidths. The power splitter 214 may have an electrical length that is configured to provide a predetermined phase shift to a signal input to the main amplifier 220, to compensate for a similar phase shift introduced by the electrical length of the impedance inverter 234 to the signal at the output of the peaking amplifier 230. For instance, in response to an RF input signal at input lead 205, the power splitter 214 may generate two signals that are 90 degrees out-of-phase with one another as inputs to the main amplifier 220 and the peaking amplifier 230, respectively. The 90 degree phase split may be used such that the output of the peaking amplifier 230 is in phase with the output of the main amplifier 220 after a 90 degree phase shift is introduced by the impedance inverter 234 (corresponding to one quarter wavelength with respect to the operating frequency of the PA 200). The output of the peaking amplifier 230, after passing through the impedance inverter 234, is combined with the output of the peaking amplifier 230 at the combining node 250. In some embodiments, a load impedance matching circuit 254 may be coupled to the output combining node 250 and configured to provide an RF output signal at output lead 295 to a load.

FIG. 2B is a circuit diagram illustrating the output section 290 of the PA 200 in greater detail. The electrical length provided by the phase delay elements of the impedance inverter circuit 234 coupled to the drain terminals 220d and 230d of the main and peaking transistor amplifiers 220 and 230 may be determined by the output (e.g., drain) capacitances of the transistor amplifiers 220 and 230 and the inductances interconnecting the drain terminals 220d and 230d to the transmission line 234. For example, as a 90° inverter 234 may require a particular characteristic impedance, and the characteristic impedance may be at least partially defined by the drain-to-source capacitance Cds of each transistor amplifier 220 and 230, the inductance may be adjusted to implement the 90° inverter 234. This inductance adjustment may be implemented using wire bonds with corresponding physical lengths; however, at higher frequencies, the electrical length may translate into a very short physical length. Thus, as the fundamental operating frequency increases, the physical length of the transmission line 234 may become shorter and shorter, and the physical distance between the drain terminals 220d and 230d may become closer and closer. That is, the electrical and physical lengths required for the impedance inverter circuit 234 may be dictated by the drain capacitances Cds and the fundamental frequency of operation of the amplifier 200.

Output matching circuits 225 and 226 (including passive components 235 and 236) may be configured in light of the above constraints. The two RF bandwidths (full power and average power) and the instantaneous bandwidth of the Doherty power amplifier 200 may be directly linked to the electrical length of the main amplifier path 225 between the transistor current source and the combining node 250 with the peaking amplifier path 226, which should be configured to provide a phase difference of about 90 degrees. Minimizing the phase delay (e.g., to 90 degrees) may improve the relative bandwidth (e.g., in comparison to a phase delay of 270 degrees, 450 degrees, etc.). However, implementing output matching circuits 225 and 226 that can satisfy all three Doherty amplifier requirements (peak power, average power, and instantaneous bandwidth) to provide broadband performance may be difficult to achieve, particularly given package size constraints.

Some conventional Doherty designs may utilize wirebonds and/or bonding pads with physical lengths that are configured to provide the required electrical length at the desired operating frequency range. For example, some conventional Doherty amplifiers may use wirebonds as interconnects between various components of the main and peaking amplifier paths, particularly in combination with active transistor devices featuring relatively large output capacitances. However, such wirebonds may provide strong coupling between wires (e.g., between series and shunt wires), resulting in power loss and reduced transformation. Reducing coupling between the paths presents challenges in the design of small Doherty amplifier modules. Also, for GaN-based devices (which may have a relatively low output capacitance and thus may require larger inductances for resonance), it may be difficult to realize the needed inductance in the low GHz range (e.g., for telecom-related operating frequency bands).

Some other conventional Doherty designs may alter the size and/or shape of the bonding pad to differently orient the wirebonds for reduced coupling. For example, shunt wires may be oriented orthogonally to series wires (and thus orthogonally to the signal propagation between the RF input and RF output terminals), which may reduce or prevent coupling between the series and shunt wires, and thereby reduce loss and provide good transformation ratio. While this arrangement may be used with transistor devices having relatively low output capacitance (e.g., GaN-based devices), it may require bonding pad layouts with specific size and/or shape requirements (e.g., C-shaped or L-shaped bonding pads with increased physical length) to provide higher inductance (for resonance with the low output capacitance) and/or additional complexities (e.g., a larger number of wires to provide sufficient current handling).

Embodiments of the present invention may arise from realization that matching circuitry using wirebond-based interconnects may become impractical or otherwise problematic for transistor devices with low output capacitance (such as GaN-based transistor devices, including GaN-on-SiC transistor devices), particularly as the physical distance between the drain terminals become closer and closer. As such, embodiments of the present disclosure include transistor amplifiers with respective matching circuits, one or more of which are implemented in configurations that may reduce or eliminate wirebonds and/or wirebond pads. While described herein primarily with reference to Group III nitride- or GaN-based semiconductor devices (such as GaN on SiC devices), it will be understood that embodiments of the present disclosure are not limited to any particular semiconductor material.

In some embodiments, one or more wirebond-based interconnects or matching circuitry components may be replaced by components or circuits that are electrically connected by conductive bumps (e.g., solder bumps), for example, in a flip-chip arrangement. As used herein, "flip chip" may refer to a configuration in which pads or terminals of a transistor device or other components are electrically connected by conductive bumps, rather than by wirebonds. Additionally or alternatively, wirebond-based interconnects or matching circuitry components may be replaced by components or circuits in or on a multi-layer laminate structure, which may be coupled to one or more terminals of active transistor devices by conductive bumps. In particular, inductors, capacitors, and/or other components of the respective matching circuits may be provided by one or more passive electrical components implemented by discrete devices (e.g., integrated passive devices (IPDs) with thin film substrates such as silicon, alumina, or glass) in a flip chip configuration and/or by elements integrated in a multi-layer laminate structure (e.g., spiral inductors), either of which may be coupled to one or more terminals of active transistor devices by conductive bumps. In embodiments described herein, at least one of the transistor amplifiers or the matching circuitry component(s) may be implemented in the flip chip configuration (i.e., flip chip implementation of the transistor devices, or flip chip implementation of the passive components, or flip chip implementation of both the transistor devices and the passive components), and may also be referred to herein as flip chip mounted components.

Implementation of the matching or passive circuit(s) and/or the transistor amplifier(s) in a flip chip configuration may allow the desired electrical length(s) to be more physically realizable, particularly for Doherty amplifiers that are configured to operate at relatively high fundamental operating frequencies, and/or to fit into relatively compact footprints. For example, implementing a shunt inductance using an IPD coupled to the output (e.g., drain) terminal of a respective transistor amplifier may achieve a relatively long electrical length (as may be needed to provide larger inductances for resonance with low output capacitances of some semiconductor materials, such as GaN) in a relatively small area, which may be critical as package sizes/distance between terminals decrease and/or as operating frequencies increase (particularly due to wirebond removal). Also, reducing bonding pad size and/or eliminating the use of wirebonds may reduce and/or eliminate signal line coupling and/or bonding pad manufacturing complexities that may be faced by some conventional devices. In addition, in some embodiments, the inductance values implemented in matching or passive circuit(s) may be easily modifiable without re-design of the amplifier layout and/or transmission line configuration. For example, modifications may be made by changing IPDs or other chip inductor values in an amplifier package, allowing for customization and/or tuning of power amplifiers as described herein with relative ease.

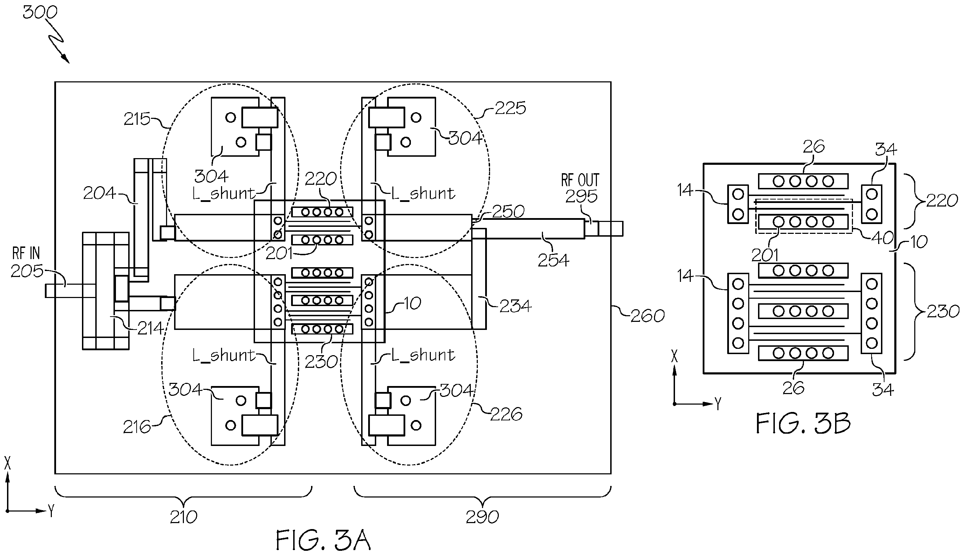

FIG. 3A is a partially transparent plan view of a PA 300 including multiple transistor amplifiers 220, 230 coupled in parallel and respective matching and phase delay circuits in accordance with some embodiments of the present invention. FIG. 3B is a partially transparent plan view illustrating the transistor amplifiers 220, 230 of FIG. 3A in greater detail.

As shown in FIGS. 3A and 3B, the PA 300 includes first and second transistor amplifiers 220 and 230 coupled between an input section 210 and an output section 290 on a substrate 260. The transistor amplifiers 220 and 230 may be formed (e.g., by epitaxial growth and other semiconductor processing and metallization steps) or otherwise provided on a semiconductor structure 10. For example, the semiconductor structure 10 may include Group III-nitride based materials (such as gallium nitride (GaN)) and/or silicon carbide (SiC). Other materials for the semiconductor structure 10 may include, but are not limited to sapphire, diamond, aluminum nitride, aluminum gallium nitride, gallium nitride, silicon, GaAs, LGO, ZnO, LAO, InP, and the like.

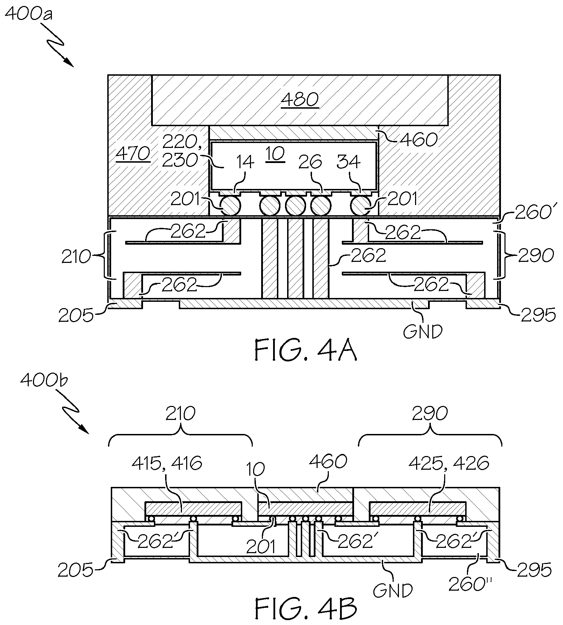

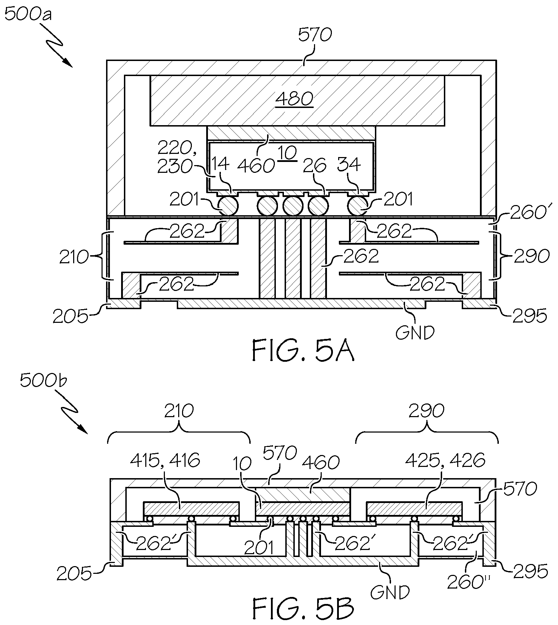

The substrate 260 may be a single- or multi-layer laminate, such as a single- or multi-layer printed circuit board (PCB). The substrate 260 includes conductive wiring or connection patterns 262 (e.g., traces, vias, interlayer wiring, etc., as shown in FIGS. 4A, 4B, 5A, and 5B) extending therein or thereon. The substrate 260 may provide a structural element or base on which the semiconductor structure 10 is attached or mounted in a transistor amplifier package, such as the example, packages 400a, 400b, 500a, and 500b discussed below with reference to FIGS. 4A, 4B, 5A, and 5B.

The conductive wiring or connection patterns 262 in the substrate 260 may electrically couple and/or may implement passive electrical components of one or more of the impedance matching circuits 215, 216, 225, 226 described herein. As such, respective input impedance matching circuits 215 and 216 may be coupled to respective input terminals (e.g., gate pads or terminals 14) of the first and second transistor amplifiers 220 and 230. Respective output terminals (e.g., drain pads or terminals 34) of the first and second transistor amplifiers 220 and 230 are coupled to a combining node 250, with respective output impedance matching circuits 225 and 226 coupled between the respective output terminals 220d and 230d and the combining node 250. Other electrical components (e.g., components of the input phase delay circuit 204, power splitter 214, impedance inverter 234, and/or load impedance matching circuit 254) may also be implemented by the conductive connection patterns 262 in or on the substrate 260. The substrate 260 may further include the input and output leads 205 and/or 295 on a surface thereof. A transistor amplifier package may thus include the semiconductor structure 10 of the transistor amplifiers 220, 230, as well the impedance matching circuits 216, 216, 225, 226, 254 phase delay elements 214, 234, and/or other circuit components that may be used to define a power amplifier 300.

At least one of the first and second transistor amplifiers 220 and 230 or the one or more passive electrical components 235 and 236 is mounted on the substrate 10 in a flip chip configuration, in which one or more terminals of the first or second transistor amplifiers 220, 230 are couped to one or more passive electrical components 235, 236 of the matching circuits 215, 216, 225, 226 by one or more conductive bumps 201. In the example of FIGS. 3A and 3B, the semiconductor structure 10 including the first and second transistor amplifiers 220 and 230 therein or thereon is mounted in the flip chip configuration on the substrate 260. The semiconductor structure 10 is shown as transparent to illustrate the respective components (i.e., the gate pad 14, the source pad 26, and the drain pad 34) of the transistor amplifiers 220 and 230 and the conductive bumps 201 that electrically connect the pads 14 and 34 matching circuits 215, 216 and 225, 226 or the passive electrical components 235, 236 thereof.

In some embodiments, the PA 300 may be implemented in a Doherty configuration, where the first transistor amplifier 220 is a main amplifier and the second transistor amplifier 230 is a peaking amplifier. The output matching circuits 225 and 226 may each be configured to delay a phase of an output signal from the one of the respective output terminals 34 to provide a predetermined phase shift. For example, the passive components 235 and 236 of the output matching circuits may provide an impedance that is 90 degrees long (i.e., so as to provide a quarter wavelength phase shift, based on a wavelength corresponding to a frequency component of the output signals) between the respective output terminals 34 and the combining node 250. In the inverted Doherty configuration shown in FIG. 3A, the impedance converter 234 provides an additional quarter wavelength or 90 degree phase shift between the output of the peaking amplifier matching circuit 226 and the combining node 250.

In some embodiments, the passive electrical component 235, 236 of the matching circuitry 225, 226 provide respective shunt inductance circuits coupled to respective drain terminals 34 of the main and/or peaking amplifiers 220, 230 by conductive bumps 201. Each shunt inductance circuit includes a shunt inductance L_shunt having an inductance value that provides at least partial resonance with the output capacitance (e.g., the drain-source capacitance C_{ds}) of the transistor device 220 or 230. That is, the shunt inductance L_shunt has an inductance value that is configured to resonate out at least a portion of the parasitic drain-source capacitance Cds of the transistor device 220, 230. In various embodiments, each shunt inductance may be terminated with a capacitance C_dec (see FIG. 2B) that provides an RF decoupling node at the fundamental operational frequency f0 of the amplifiers 220, 230.

In some embodiments, the shunt inductance L_shunt may be implemented by one or more IPDs or other flip chip mounted discrete components. As noted above, IPDs may include discrete inductors and/or other passive electrical components, and may be fabricated using standard semiconductor processing techniques such as thin film and/or photolithography processing. IPDs can be flip chip mountable, and may include thin film substrates such as silicon, alumina, or glass. The IPDs may be mounted on the surface of the substrate 260 in a flip chip configuration and coupled to the output terminals 34 of the main amplifier 220 or the peaking amplifier 230 by the conductive bumps 201. In some embodiments, the shunt inductance L_shunt may be implemented by distributed elements or structures within the substrate 260 (e.g., by conductive and/or insulating layer patterns fabricated using semiconductor processing techniques), and may be coupled to the output terminals 34 of the main amplifier 220 or the peaking amplifier 230 by the conductive bumps 201. More generally, the shunt inductance L_shunt can be implemented without or free of wirebonds, and the drain terminal 34 can be coupled to the shunt inductance L_shunt free of a wire bond pad therebetween.

The flip chip mounted discrete components and/or structures within the substrate 260 may similarly be used to implement other passive electrical components 235, 236 (e.g., series inductance L_ser, capacitances C_dec, C_ser, C_shunt; see FIG. 2B) of the impedance matching circuits 215, 216, 225, 226. As shown in the example of FIG. 3A, the decoupling capacitance C_dec may be implemented by one or more capacitor dies 304 mounted in a flip chip configuration on the surface of the substrate 260. The capacitor dies 304 may also implement other capacitances (e.g., C_ser, C_shunt) of the impedance matching circuits 215, 216, 225, 226.

As such, the matching circuits 215, 216, 225, and/or 226 may be implemented by one or more flip chip IPDs and capacitor dies, which provide L-C matching circuits at the fundamental frequency f0, as well as a shunt inductance L_shunt and the decoupling capacitance C_dec connected to a ground lead GND. However, as similarly noted above, the inductances (e.g., L_shunt, L_ser) and/or capacitances (e.g., C_dec, C_ser, C_shunt) may additionally or alternatively be implemented by one or more structures in the substrate 260. More generally, one or more passive electrical components may be implemented using discrete flip chip components and/or distributed components within the substrate or laminate 260, such that an electrical path between at least one of the respective output terminals 34 and the combining node 250 is free of wirebonds and/or wirebond pads.

In some embodiments, elimination of wirebonds and/or wirebond pads in parallel stage transistor amplifier packages according to some embodiments of the present disclosure, such as in the Doherty amplifier configurations described herein, may allow for increased bit rate and/or efficiency, for example, in telecommunications applications. In particular embodiments, shunt inductances Ls sufficient for resonance with GaN-based and/or other low Cds/mm materials may be directly coupled (e.g. by conductive bumps 201) to the output terminal 34 (e.g., the drain pad) of the respective transistor amplifiers 220 and/or 230, by implementing at least one of the transistor amplifiers 220, 230 or the passive electrical components 235, 236 using flip chip configurations. The shunt inductance Ls may be provided as the first element of the matching circuits 225, 226 (e.g., coupled directly to the drain terminals, so as to be implemented as close as possible to the outputs of the respective transistor amplifiers 220, 230), which may reduce or minimize the required inductance.

FIGS. 3A and 3B illustrate an asymmetric Doherty PA arrangement 300 in which the peaking amplifier 330 includes more unit cell transistors 40 than the main amplifier 320, which may provide higher power handling capability. However, it will be understood that embodiments described herein are not limited to such an arrangement. Some embodiments may include symmetric Doherty or other load modulation amplifier arrangements in which the main amplifier 320 and the peaking amplifier 330 include the same number of unit cell transistors 40 to provide the same power handling capability. As discussed in further detail below, bandwidth may be optimized by providing the output impedance matching circuits 225, 226 and/or the load impedance matching circuit 254 with respective electrical lengths that are based on the relative power characteristics between the main amplifier 220 and the peaking amplifier 230, which may be quantified as a ratio of peaking amplifier power to main amplifier power (also referred to as an asymmetry factor).

FIGS. 4A, 4B, 5A, and 5B are cross-sectional views illustrating example transistor amplifier packages in accordance with some embodiments of the present disclosure. In particular, FIGS. 4A and 5A illustrate transistor amplifier packages 400a and 500a in which the semiconductor structure 10 (including the transistor amplifiers 220, 230) is flip chip mounted on a substrate 260' by conductive bumps 201, and the input and output sections 210 and 290 (including the matching circuits 215, 216 and 225, 226) of the power amplifier 300 are implemented by distributed element structures within the layers of the substrate 260'. FIGS. 4B and 5B illustrate transistor amplifier packages 400b and 500b in which the semiconductor structure 10 (including the transistor amplifiers 220, 230) and also one or more passive components of the input and output sections 210 and 290 are flip chip mounted on a substrate 260" by conductive bumps 201.

In the examples of FIGS. 4A and 5A, the substrate 260' is a multi-layer laminate (such as PCB) that includes conductive layer patterns 262" and/or conductive vias 262' (collectively referred to as conductive connection patterns 262) that are electrically connected to respective terminals 14, 26, 34 of the transistor amplifiers 220, 230 by conductive bumps 201. The multi-layer laminate 260' and conductive connection patterns 262 may be fabricated using semiconductor processing techniques by depositing conductive and insulating layers and/or patterns on a base material and by forming vias and conductive routing patterns within the structure.

Still referring to FIGS. 4A and 5A, the conductive connection patterns 262 and related structures in the multi-layer laminate 260' may be configured to provide distributed circuit elements that implement passive components of the matching circuits 215, 216, 225, 226 and other circuits 204, 214, 234, 254 of the input section 210 and the output section 290 of the PA 300 shown in FIG. 3A. For example, the conductive connection patterns 262 and related structures in the multi-layer laminate 260' may be configured to provide matching circuits 225, 226 of the output section 290, each including a shunt inductance L_shunt that is coupled to a drain terminal 34 of a respective transistor amplifier 220, 230 of the semiconductor structure 10 by conductive bumps 201. The conductive connection patterns 262 and related structures in the multi-layer laminate 260' may be similarly configured to provide matching circuits 215, 216 of the input section 210 coupled to gate terminals 14 of the transistor amplifiers 220, 230 by conductive bumps 201, and to couple the source terminals 26 of the respective transistor amplifiers 220, 230 to a ground reference GND.

In the examples of FIGS. 4B and 5B, the substrate 260" is a single- or multi-layer laminate (such as a PCB) that includes conductive vias 262' that are electrically connected to respective terminals 14, 26, 34 of the transistor amplifiers 220, 230 by conductive bumps 201. Passive components of the matching circuits 215, 216, 225, 226 and/or of the circuits 204, 214, 234, 254 of the input section 210 and the output section 290 of the PA 300 shown in FIG. 3A are implemented by flip-chip components, illustrated as input IPD(s) 415, 416 and output IPD(s) 425, 426. For example, the output IPD(s) 425, 426 may be configured to provide matching circuits 225, 226 of the output section 290, each including a shunt inductance L_shunt that is coupled to a drain terminal 34 of a respective transistor amplifier 220, 230 of the semiconductor structure 10 by conductive bumps 201. The input IPD(s) 415, 416 may be similarly configured to provide matching circuits 215, 216 of the input section 210 coupled to gate terminals 14 of the transistor amplifiers 220, 230 by conductive bumps 201. The source terminals 26 of the respective transistor amplifiers 220, 230 may be coupled to a ground reference GND by conductive bumps 201 and conductive vias 262' extending through the substrate 260".

In FIGS. 4A, 4B, 5A, and 5B, the semiconductor structure 10 (including the transistor amplifiers 220, 230) is flip chip mounted on the substrate 260', 260". The gate, source, and drain terminals 14, 26, and 34 are provided on one surface of the semiconductor structure 10, which is mounted face-down on the substrate 260', 260" such that the terminals 14, 26, 34 are coupled to conductive connection patterns 262 by conductive bumps 201. The opposite surface of the semiconductor structure 10 includes a thermal interface material (TIM) 460 thereon. The TIM 460 is configured to transfer heat generated from the semiconductor structure 10 to a heat sink (shown as heat spreader 480 in FIG. 4A). The TIM 460 may be electrically and thermally conducting, or thermally conducting but electrically insulating. In some embodiments, the TIM 460 may not be present.

The transistor amplifier packages 400a, 400b, 500a, and 500b of FIGS. 4A, 4B, 5A, and 5B, each include the semiconductor structure 10 (including the first and second transistor amplifiers 220 and 230) and the input and output sections 210, 290 (including the matching circuits 215, 216, 225, 226, phase delay circuits 204, 234, and other circuits 214, 254) sealed or otherwise protected in a package housing. For example, FIGS. 4A and 4B illustrate overmold packages 400a and 400b, while FIGS. 5A and 5B illustrate open cavity packages 500a and 500b.

In FIGS. 4A and 4B, the transistor amplifier packages 400a, 400b each include an overmold structure 470 covering or at least partially encapsulating the semiconductor structure 10 and the substrate 260', 260". The example transistor amplifier packages 400a, 400b also include a heat dissipating member having a surface that is exposed by the overmold structure 470 (a top surface of the heat spreader 480 in FIG. 4A; a top surface of the TIM 460 in FIG. 4B) for top side cooling, but it will be understood the overmold structure 470 may fully encapsulate the semiconductor structure 10 in some embodiments.

In FIGS. 5A and 5B, the transistor amplifier packages 500a, 500b each include a lid member 570 protecting the semiconductor structure 10 and the substrate 260', 260". The lid member 570 may include ceramic materials (e.g., alumina) and may define an open cavity at least partially surrounding the components 10, 260', 260". In some embodiments, the lid member 570 may be a thermally conductive material for dissipating or otherwise transmitting heat outside of the packages 500a, 500b. The example transistor amplifier packages 500a, 500b also include a heat dissipating member having a surface that is in contact with the lid member 570 (a top surface of the heat spreader 480 in FIG. 5A; a top surface of the TIM 460 in FIG. 5B).

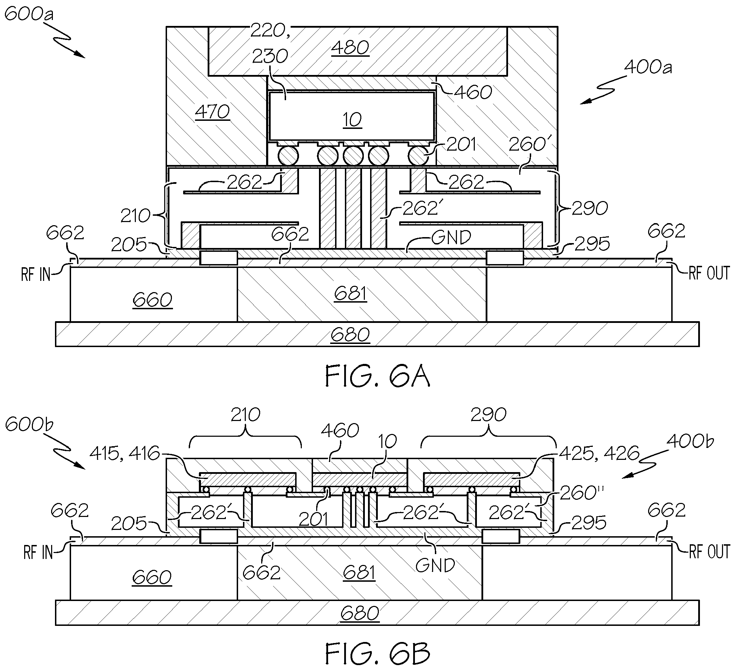

Still referring to FIGS. 4A, 4B, 5A, and 5B, RF input leads 205 and RF output leads 295 are provided on surfaces of the substrate 260', 260" for attachment and/or coupling to external devices, such as a circuit board 660 as shown in FIGS. 6A and 6B. While illustrated in the figures as being provided on an opposite surface of the substrate 260', 260" than the semiconductor structure 10, it will be understood that transistor amplifier packages as described herein are not limited to such an arrangement, and the RF input leads 205 and RF output leads 295 may be provided on the same surface of the substrate 260', 260" as the semiconductor structure 10 in some embodiments. Also, it will be understood the heat dissipating members 480 and/or 460 may not be present in some embodiments.

FIGS. 6A and 6B are cross-sectional views illustrating example products or applications including transistor amplifier packages in accordance with some embodiments of the present disclosure. While illustrated in FIGS. 6A and 6B with reference to the packages 400a and 400b of FIGS. 4A and 4B for purposes of illustration, it will be understood that the packages 500a and 500b of FIGS. 5A and 5B (or more generally, other packages in accordance with embodiments of the present disclosure) may be similarly provided.

In FIGS. 6A and 6B, example products 600a, 600b may electrically couple the RF input leads 205 and RF output leads 295 of the transistor amplifier package 400a, 400b to a surface of external integrated circuit, such as a circuit board 660. The circuit board 660 includes conductive elements or traces 662 on a surface thereof, and the transistor amplifier package 400a, 400b may be configured such that the RF input leads 205, RF output leads 295, and ground reference GND are aligned with corresponding ones of the conductive elements 662 for electrical connection.

In the examples of FIGS. 6A and 6B, the circuit board 660 further includes an integrated thermal dissipation member, illustrated by way of example as a thermally conductive coin 681 that extends through the circuit board 660 and a heat sink 680 on a surface of the circuit board 660 opposite to the surface on which the transistor amplifier package 400a, 400b is mounted. As such, the example product applications 600a, 600b may include multiple thermally conductive paths for dissipating heat away from the semiconductor structure 10. In particular, heat may be dissipated from a first thermal path at the top side of the products 600a, 600b, as defined by the heat spreader 480 (in FIG. 6A) and the TIM 460 (in FIG. 6B), which are exposed by respective overmold members 470 of the packages 400a, 400b. Heat may also be dissipated by a second thermal path at the bottom side of the products 600a, 600b, as defined by the conductive connections 262, the ground reference GND, the conductive elements 662, the coin 681, and the heatsink 680 (which may also provide an electrical path to a ground connection).

The circuit board 660 may include additional active and/or passive electrical components in some embodiments. For example, the circuit board 660 may include additional passive electrical components that are configured to provide input and/or output pre-matching circuits for the transistor amplifiers 220, 230.

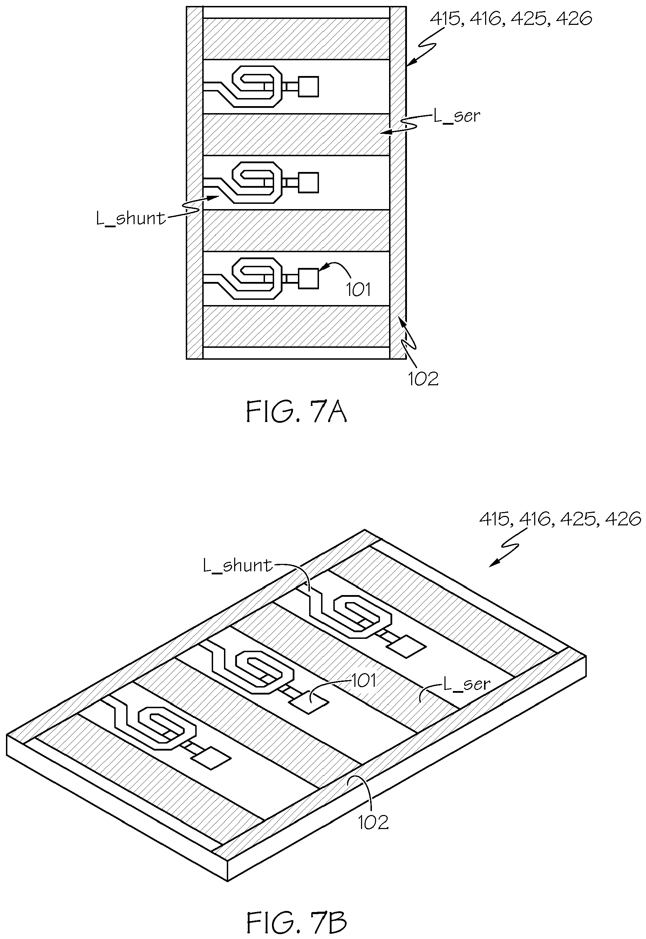

FIGS. 7A and 7B are plan and perspective views, respectively, illustrating examples of IPDs 415, 416, 425, 426 that may be used to implement passive electrical components for matching circuits and/or phase delay circuits in accordance with some embodiments of the present disclosure. As noted above, IPDs may include inductors and/or other passive electrical components, and may be fabricated using standard semiconductor processing techniques such as thin film and/or photolithography processing. IPDs can be flip chip mountable or wire bondable components, and may include thin film substrates such as silicon, alumina, or glass.

In the examples of FIGS. 7A and 7B, the IPDs 415, 416, 425, 426 may be configured to provide shunt inductances with precise inductance values for bandwidth optimization, for example, using coil or spiral inductors L_shunt. The shape, width and general design of the coil inductors L_shunt may be configured and/or optimized to reduce losses. One end of the coil inductors L_shunt may include a bump or contact pad 101, which can be pre-attached with conductive bumps (e.g., 201) for flip chip connection to respective input or output terminals 14, 34 of the transistor amplifiers 220, 230.

The IPDs 415, 416, 425, 426 may also be configured to provide additional impedances, for example, series inductances using series connection strips L_ser. The widths of the series connection strips L_ser can be configured to provide the desired impedance transformation for the matching circuits 215, 216, 225, 226 and/or the phase delay circuits 204, 234. The series connection strips L_ser may extend between bump or contact pads 102, and the width of each series connection strip L_ser can be configured to provide the desired characteristic impedance. More generally, any of the passive electrical components described herein may be implemented by IPDs 415, 416, 425, 426 including series connection strips L_ser that are coupled to contact pads 102 and/or coil inductors Ls that are coupled to contact pads 101 for connection to respective terminals 14, 34 of transistor amplifiers 220, 230 as described herein.

In addition or alternatively, the passive electrical components described herein may be implemented by one or more distributed elements that are configured to provide the respective phase shift(s).

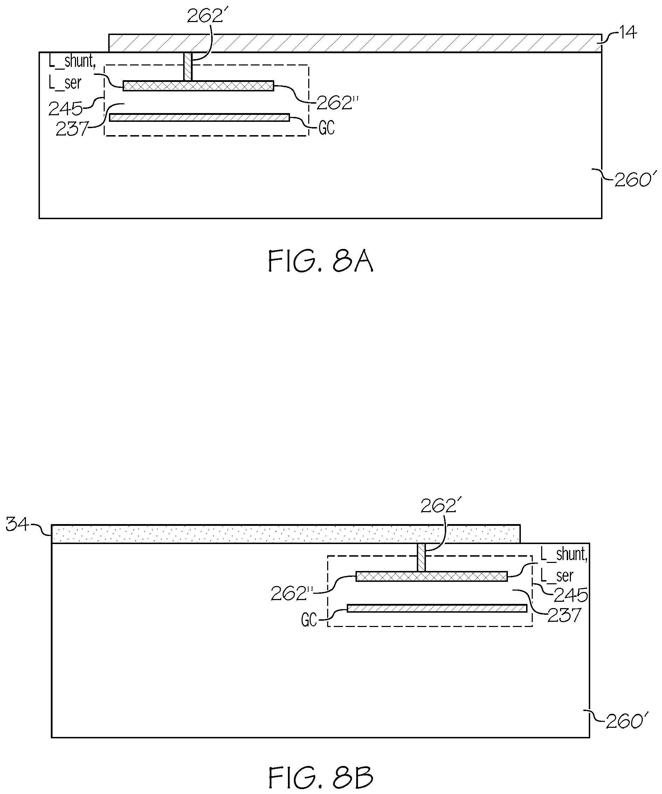

FIGS. 8A and 8B are cross sectional views illustrating distributed element circuits 245 in a substrate 260' that may be used to implement passive electrical components for matching circuits and/or phase delay circuits in accordance with some embodiments of the present disclosure. For example, passive electrical components defining the output matching circuits 225 and/or 226 may be implemented as inductors and/or capacitors 245 implemented by metal and/or wiring layers 262 in or on one or more layers of the substrate or laminate 260', which may be connected to input terminal 14 (in FIG. 8A) or the output terminal 34 (in FIG. 8B) of the transistor amplifiers 220, 230 by a conductive vias 262'.

As shown by way of example in the cross-sectional views of FIGS. 8A and 8B, a distributed circuit element 245 in a substrate or laminate 260' may include an inductive element L_shunt, L_ser formed by a conductive element 262" (e.g., a wiring layer) and electrically connected to the gate 14 or drain 34 by respective conductive vias 262'. Additionally or alternatively, the distributed circuit elements 245 may include a capacitance C formed between a conductive element 262" (e.g., a wiring layer) and a ground conductor GC separated by one or more dielectric layers 237. The capacitance C may be coupled to the gate 14 or drain 34 by respective conductive vias 262', and may be configured to provide any of the capacitances (e.g., C_dec, C_shunt, C_ser) described herein. Dielectric layer 237 may include one or more dielectrics or layers having electrical characteristics appropriate for forming a capacitance between the wiring layer 262 and the ground conductor GC, for example, silicon oxide, silicon nitride, silicon oxynitride, a high-dielectric, or a combination thereof, though embodiments described herein are not limited thereto.

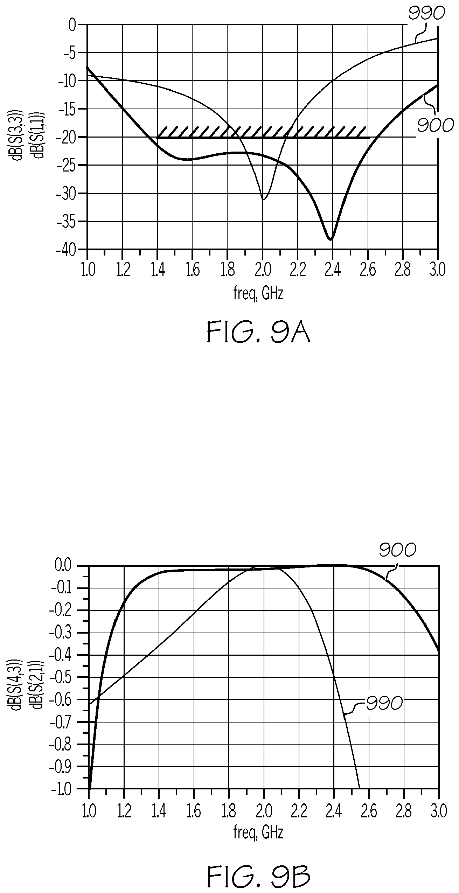

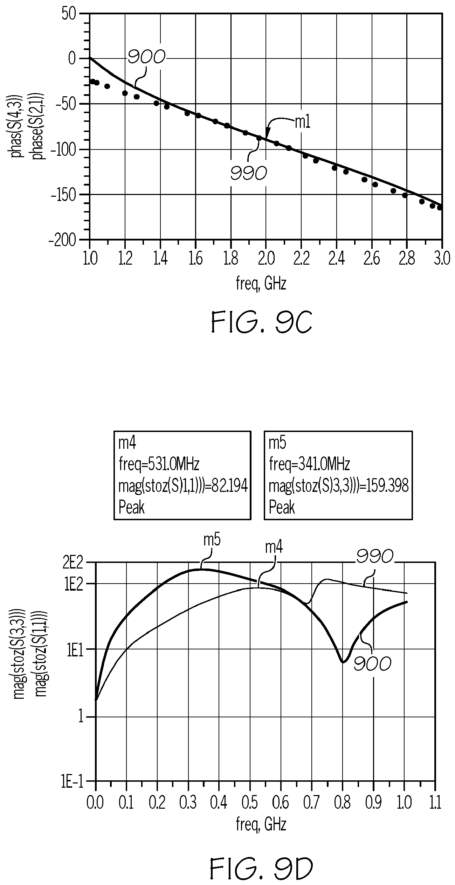

FIGS. 9A, 9B, 9C, and 9D are graphs illustrating performance of output matching circuits configured for increased or optimized bandwidths (including both RF and instantaneous bandwidths) in PAs in accordance with some embodiments of the present disclosure. In particular, the graphs of FIGS. 9A to 9D illustrate performance of embodiments of the present disclosure (shown by line 900), which include output matching circuits having a shunt inductance that is coupled to the drain terminal of a respective transistor amplifier, in comparison with output matching circuits that omit the shunt inductance and include a series inductance coupled to the drain terminal of a respective transistor amplifier (shown by line 990). In greater detail, FIG. 9A illustrates main current source plane matching; FIG. 9B illustrates current source to load power transfer; FIG. 9C illustrates current source to load power transfer phase; and FIG. 9C illustrates VBW performance as baseband resonance in the current source plane.

As shown in FIGS. 9A to 9D, matching circuits including a shunt inductance that is coupled to the drain terminal of a respective transistor amplifier as described herein may be critical in substantially increasing RF bandwidth (e.g., about 1.4 GHz to about 2.6 GHz) and baseband resonance (e.g., about 531 MHz) in comparison to series inductance implementations (with a narrower RF bandwidth of about 1.9 GHz to about 2.1 GHz and baseband resonance of about 341 MHz). For example, Doherty RF bandwidth optimization in accordance with some embodiments may utilize a shunt inductance as a first matching element (i.e., directly coupled to the drain terminal) to provide the matching network between the main current source and the combining node with an electrical length of 90°. In addition, providing the shunt inductance in the drain plane (for impedance matching, rather than as a choke) may achieve improved or optimum SBW performance.

In some embodiments, the transistor amplifiers may be configured in a Doherty arrangement, and the matching circuits may be configured to improve and/or optimize multiple Doherty amplifier bandwidths (e.g., peak/full RF power, average/back-off RF power, and IBW) at the same time. For example, the load impedance matching circuit 254 may be configured to provide an electrical length that is based on the relative power characteristics between the main amplifier 220 and the peaking amplifier 230. In particular, an asymmetry factor α may be defined as ratio of peaking amplifier power P_Peak to the main amplifier power P_Main, while a load modulation index may be defined as 1+ α.

Some embodiments may arise from realization that impedances R_match of the respective output matching circuits 225, 226 for a PA 300 (e.g., for transistor amplifiers 220, 230 in an inverted Doherty configuration) may be based on the cascade of the main output matching circuit 225 and the load impedance matching circuit 254 between the combining node 250 and the load. A main output matching circuit 225 with an electrical length of 90° may be perfectly balanced with respect to full power and the average power. The load impedance matching circuit 254 (between the combining node 250 and the output lead 295/load) may not be constrained in electrical length, and thus, can be configured as needed for bandwidth optimization. In particular, one or more PA bandwidths may be improved or optimized by providing the load impedance matching circuit 254 (the section between the combining node 250 and the output lead 295) with an electrical length that is based on the asymmetry factor (or modulation index) of the main 220 and peaking 230 amplifiers.

For example, in a symmetrical Doherty configuration, with P_Peak = P_Main, asymmetry factor α =1, and load modulation index = 2, improved or optimum bandwidths may be achieved when the impedance at the combining node 250 is equal to about 2 times the impedance R_main seen at the input to the main output matching circuit 225. In an example asymmetrical Doherty configuration, with P_Peak = 2 x P_Main , asymmetry factor α = 2, and load modulation index = 3, improved or optimum bandwidths may be achieved when the impedance at the combining node 250 is about 3 times the impedance R_main seen at the input to the main output matching circuit 225. As such, in some embodiments, an impedance at the combining node 250 (e.g., the impedance of the load impedance matching circuit 254) may be about 1.5 times to 4 times (for example, about 2 times to 3 times) an impedance R_main at the output terminal of the main amplifier 220 (i.e., at the input to the matching circuit 225), for asymmetry factors of 1 to 2. In some embodiments, optimum RF bandwidth may be achieved when the impedance ratio (i.e., the ratio of the impedance at the combining node 250 to the impedance R_main seen at the input to the main output matching circuit 225) is equal to the load modulation index.

As described herein, embodiments of the present disclosure provide transistor structures and a matching topology configured using conductive bumps and/or flip chip arrangements (which may include flip chip mounting of the transistor amplifiers, the passive components of the matching circuits, or both), which can reduce or eliminate the use of wirebonds and/or wirebond pads. In particular, some embodiments described herein provide output matching circuits including a shunt inductance directly in the drain plane of a transistor amplifier, that is, directly coupled to the drain terminal of the transistor amplifier by one or more conductive bumps. Particular embodiments may provide an output section including a shunt inductance with bumped GaN on SiC transistors.

As noted above, providing the shunt inductance Ls as the first element of the matching circuits 225, 226 (e.g., as close as possible to the output terminals of the respective transistor amplifiers 220, 230) may reduce or minimize the required inductance for resonance with the output capacitance, thereby reducing operating frequency limitations. Frequency limitations may be further reduced by eliminating capacitive parasitics associated with the bonding pads used for wirebond connections. Some embodiments may also include multiple thermal/heat dissipation paths, thereby improving thermal performance. The improved thermal performance may also allow for increased RF bandwidth by the use of fundamental loads. In greater detail, as thermal performance is improved, a smaller device can be used, with a power loading closer to maximum power. The electrical effect of this may be a lower output impedance Q, which may allow for broader RF bandwidth.

Embodiments of the present disclosure may be used in various cellular infrastructure (CIFR) RF power products (including, but not limited to 5W, 10W, 20W, 40W, 60W, 80W and different frequency bands) e.g., for 5G and base station applications, as well as for radar and monolithic microwave integrated circuit (MMIC)-type applications. Broadband Doherty amplifiers (e.g., with greater than about 40% relative bandwidth) as described herein may also be used in aerospace and defense (A&D) and portable applications. Although described herein primarily with reference to Doherty implementations, in some embodiments, the packaged transistor amplifiers may more generally include multiple transistor dies that are connected in parallel amplifier paths to form a transistor device with multiple transistor dies and multiple paths, such as in a dual-path driver amplifiers, or other multi-stage power amplifiers.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" "comprising," "includes" and/or "including" when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms used herein should be interpreted as having a meaning that is consistent with their meaning in the context of this specification and the relevant art and will not be interpreted in an idealized or overly formal sense unless expressly so defined herein.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "lateral" or "vertical" may be used herein to describe a relationship of one element, layer or region to another element, layer or region as illustrated in the figures. It will be understood that these terms are intended to encompass different orientations of the device in addition to the orientation depicted in the figures.

Embodiments of the invention are described herein with reference to cross-section illustrations that are schematic illustrations of idealized embodiments (and intermediate structures) of the invention. The thickness of layers and regions in the drawings may be exaggerated for clarity. Additionally, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Elements illustrated by dotted lines may be optional in the embodiments illustrated.

Like numbers refer to like elements throughout. Thus, the same or similar numbers may be described with reference to other drawings even if they are neither mentioned nor described in the corresponding drawing. Also, elements that are not denoted by reference numbers may be described with reference to other drawings.

In the drawings and specification, there have been disclosed typical embodiments of the invention and, although specific terms are employed, they are used in a generic and descriptive sense only and not for purposes of limitation, the scope of the invention being set forth in the following claims.

## Claims

1. A power amplifier, comprising:
a substrate;
first and second transistor amplifiers, wherein respective output terminals of the first and second transistor amplifiers are coupled to a combining node; and
a matching circuit comprising one or more passive electrical components coupled between one of the respective output terminals and the combining node,
wherein at least one of the first and second transistor amplifiers or the one or more passive electrical components is mounted on the substrate in a flip chip configuration.

2. The power amplifier of Claim 1, wherein the one of the respective output terminals is a drain terminal, and wherein the one or more passive electrical components comprises a shunt inductance that is coupled to the drain terminal by a conductive bump.

3. The power amplifier of Claim 2, wherein the one or more passive electrical components comprises at least one integrated passive device (IPD) that is mounted on the substrate in the flip chip configuration and provides the shunt inductance or wherein the substrate comprises a multi-layer laminate, and the one or more passive electrical components comprises at least one inductor that is in the multi-layer laminate and provides the shunt inductance.

4. The power amplifier of Claim 2 or Claim 3, wherein the shunt inductance is free of wirebonds and/or wherein the drain terminal is coupled to the shunt inductance free of a wire bond pad therebetween.

5. The power amplifier of any of Claims 2 to 4, wherein the one of the respective output terminals is a drain terminal of the first transistor amplifier, the matching circuit is a first output matching circuit, and the shunt inductance is a first shunt inductance, and further comprising:
a second output matching circuit coupled between a drain terminal of the second transistor amplifier and the combining node, the second output matching circuit comprising a second shunt inductance coupled to the drain terminal of the second transistor amplifier by a conductive bump.

6. The power amplifier of any preceding Claim, wherein the first and second transistor amplifier dies comprise a main amplifier and a peaking amplifier, respectively, in a Doherty configuration.

7. The power amplifier of Claim 6, further comprising:
a load impedance matching circuit coupled between the combining node and an output lead,
wherein an impedance of the load impedance matching circuit is based on an asymmetry factor between the peaking amplifier and the main amplifier and is about 1.5 times to 4 times an impedance at the output terminal of the main amplifier.

8. The power amplifier of any preceding Claim, wherein one or more of:
the matching circuit is configured to delay a phase of an output signal from the one of the respective output terminals by a quarter wavelength;
an electrical path between the one of the respective output terminals and the combining node is free of wirebonds; and
the power amplifier further comprises a package housing including the substrate, the first and second transistor amplifiers, and the matching circuit therein.

9. A transistor amplifier package, comprising:
a main transistor amplifier; and
a peaking transistor amplifier, wherein respective output terminals of the main and peaking transistor amplifiers are coupled to a combining node,
wherein an electrical path between one of the respective output terminals and the combining node is free of wirebonds.

10. The transistor amplifier package of Claim 9, further comprising:
a matching circuit comprising one or more passive electrical components coupled between the one of the respective output terminals and the combining node.

11. The transistor amplifier package of Claim 10, wherein the one of the respective output terminals is a drain terminal, and wherein the one or more passive electrical components comprises a shunt inductance that is coupled to the drain terminal by a conductive bump.

12. The transistor amplifier package of Claim 11, further comprising a substrate, wherein at least one of the main and peaking transistor amplifiers or the one or more passive electrical components is mounted on the substrate in a flip chip configuration.

13. The transistor amplifier package of Claim 12, wherein the one or more passive electrical components comprises at least one integrated passive device (IPD) that is mounted on the substrate in the flip chip configuration and provides the shunt inductance or wherein the substrate comprises a multi-layer laminate, and the one or more passive electrical components comprises at least one inductor that is in the multi-layer laminate and provides the shunt inductance.

14. The transistor amplifier package of any of Claims 11 to 13, wherein the one of the respective output terminals is a drain terminal of the main transistor amplifier, the matching circuit is a first output matching circuit configured to delay a phase of an output signal from the main transistor amplifier by a quarter wavelength, and the shunt inductance is a first shunt inductance, and further comprising:
a second output matching circuit coupled between a drain terminal of the peaking transistor amplifier and the combining node and configured to delay a phase of an output signal from the peaking transistor amplifier by a quarter wavelength, the second output matching circuit comprising a second shunt inductance coupled to the drain terminal of the peaking transistor amplifier by a conductive bump.

15. The transistor amplifier package of any of Claims 9 to 14, further comprising:
a load impedance matching circuit coupled between the combining node and an output lead of the transistor amplifier package,
wherein an impedance of the load impedance matching circuit is about 1.5 times to 4 times an impedance at the output terminal of the main transistor amplifier.
